# EUROPÄISCHE PATENTSCHRIFT

(11) **EP 1 565 988 B1**
(45) Veröffentlichungstag und Bekanntmachung des Hinweises auf die Patenterteilung: **21.09.2011**
(21) Anmeldenummer: 03789091.0
(22) Anmeldetag: 26.11.2003
(51) Int. Cl.: H03K 19/18

(54) **MAGNETISCHE LOGIKEINRICHTUNG**
MAGNETIC LOGIC DEVICE
DISPOSITIF LOGIQUE MAGNETIQUE

(30) Priorität: 29.11.2002 DE 10255857
(43) Veröffentlichungstag der Anmeldung: 24.08.2005
(73) Patentinhaber: Forschungsverbund Berlin e.V., 12489 Berlin (DE)
(72) Erfinder: KOCH, R, Paul-Drude-Inst.für Festkörperelektronik, 10117 Berlin (DE); PAMPUCH, C, Paul-Drude-Inst.für Festkörperelekt., 10117 Berlin (DE); NEY, Andreas, 47055 Duisburg (DE); PLOOG, Klaus, H., 15566 Schöneiche (DE)
(74) Vertreter: Hertz, Oliver
(86) Internationale Anmeldenummer: PCT/EP2003/013318
(87) Internationale Veröffentlichungsnummer: WO 2004/051853

(56) Entgegenhaltungen:
- DE-A- 10 036 356
- DE-C1- 10 053 206
- US-A- 5 629 549
- US-A- 6 140 838
- US-A1- 2001 026 158
- A. NEY ET AL.: "Programmable Computing with a single magnetoresistive element" NATURE, Nr. 425, Seiten 485-487, XP002295128 Gefunden im Internet: URL:http://www.nature.com/cgi-taf/DynaPage .taf?file=/nature/journal/v425/n6957/full/ nature02014_r.html&filetype=&dynoptions=> [gefunden am 2004-09-07]
- RICHTER R ET AL: "Tunneling systems for field programmable spin-logic gates" JOURNAL OF APPLIED PHYSICS, AMERICAN INSTITUTE OF PHYSICS. NEW YORK, US, Bd. 91, Nr. 10, 15. Mai 2002 (2002-05-15), Seiten 8402-8404, XP012055156 ISSN: 0021-8979 -& RICHTER R ET AL: "Nonvolatile field programmable spin-logic for reconfigurable computing" APPLIED PHYSICS LETTERS, AMERICAN INSTITUTE OF PHYSICS. NEW YORK, US, Bd. 80, Nr. 7, 18. Februar 2002 (2002-02-18), Seiten 1291-1293, XP012031618 ISSN: 0003-6951 -& RICHTER R ET AL: "Field programmable spin-logic realized with tunnelling-magnetoresistance devices" SOLID STATE ELECTRONICS, ELSEVIER SCIENCE PUBLISHERS, BARKING, GB, Bd. 46, Nr. 5, Mai 2002 (2002-05), Seiten 639-643, XP004346691 ISSN: 0038-1101 -& RICHTER R ET AL: "Field programmable spin-logic based on magnetic tunnelling elements" JOURNAL OF MAGNETISM AND MAGNETIC MATERIALS, ELSEVIER, AMSTERDAM, N
- HANBICKI A T ET AL: "NONVOLATILE REPROGRAMMABLE LOGIC ELEMENTS USING HYBRID RESONANT TUNNELING DIODE-GIANT MAGNETORESISTANCE CIRCUITS" APPLIED PHYSICS LETTERS, AMERICAN INSTITUTE OF PHYSICS. NEW YORK, US, Bd. 79, Nr. 8, 20. August 2001 (2001-08-20), Seiten 1190-1192, XP001082284 ISSN: 0003-6951
- BLACK W C ET AL: "PROGRAMMABLE LOGIC USING GIANT-MAGNETORESISTANCE AND SPIN-DEPENDENTTUNNELING DEVICES (INVITED)" JOURNAL OF APPLIED PHYSICS, AMERICAN INSTITUTE OF PHYSICS. NEW YORK, US, Bd. 87, Nr. 9, 1. Mai 2000 (2000-05-01), Seiten 6674-6679, XP000954082 ISSN: 0021-8979 in der Anmeldung erwähnt

## Beschreibung

Die Erfindung betrifft Verfahren zum Betrieb einer magnetischen Logikeinrichtung, mit der bei mindestens einer Logikoperation mittels eines magnetischen Bauelements aus logischen Eingangsgrößen mindestens eine logische Ausgangsgröße gebildet wird. Die Erfindung betrifft auch magnetische Logikeinrichtungen zur Durchführung derartiger Verfahren und Logikschaltungen, die mit einer Vielzahl derartiger Logikeinrichtungen ausgestattet sind.

Logikschaltungen, die aus einer Vielzahl frei programmierbarer Bauelemente bestehen und rekonfigurierbare Systeme bilden, sind allgemein bekannt. Es ist beispielsweise eine Anordnung programmierbarer Logikeinrichtungen vorgesehen, die über programmierbare Verbindungen je nach der aktuellen Aufgabe koppelbar sind (sogenannte "Field Programmable Gate Arrays, FPGA"). FPGA-Schaltungen benötigen für die Programmierbarkeit Halbleiterbauelemente, die mit Hilfe eines gespeicherten Ladungszustandes die Logik der Schaltung festlegen. Dafür werden ferroelektrische Materialien verwendet, die prinzipiell in der Lage sind, eine Ladung über eine lange Zeit zu speichern und damit einen definierten Zustand stabil zu halten. Nachteilig ist jedoch, dass Umprogrammierungen, bei denen die Ladung verändert wird, mit einer mechanischen Belastung des speichernden Materials verbunden sind. Daher sind die Betriebsfrequenz und die Lebensdauer von Logikeinrichtungen mit ferroelektrischen Speichern begrenzt.

Die Beschränkung auf eine bestimmte Anzahl von Umschaltzyklen kann mit magnetischen Logikeinrichtungen überwunden werden, deren logische Funktion beispielsweise durch ein magnetoresitives Element (im Folgenden: MR-Element) ausgeführt wird. MR-Elemente besitzen einen elektrischen Widerstand, der auf der Grundlage z. B. des GMR- (giant magnetoresistive) oder des TMR- (tunneling magnetoresistive)-Effekts durch ein äußeres Magnetfeld verändert und zur Erzeugung von logischen Signalen verwendet werden kann (siehe W. C. Black et al. in "Journal of Applied Physics", Band 87, 2000, S. 6674-6679).

MR-Elemente, die in der Regel Dünnschichtbauelemente sind, können beliebig oft umgeschaltet werden und sind dadurch gekennzeichnet, dass ein aktueller Betriebszustand (hier: Magnetisierungszustand) spannungslos gespeichert wird (Nichtflüchtigkeit der Information). Daher besitzen MR-Bauelemente eine erheblich reduzierte Leistungsaufnahme und des weiteren die Fähigkeit, Informationen prinzipiell mit extrem kurzen Impulsen (fs) und extrem hohen Frequenzen (GHz) zu schreiben oder zu lesen (siehe T. Gerrits et al. in "Nature", Band 418, 2002, S. 509). Bisher werden MR-Elemente wegen der genannten Vorteile als Speicherbausteine (MRAM, Magnetic Random Access Memory, siehe z.B. DE 198 53 447), d. h. als passives Bauelement verwendet. Es gibt Versuche, MR-Elemente auch als aktive Bauelemente in Logikeinrichtungen zu verwenden, wie im Folgenden dargestellt wird.

In DE 101 36 356 ist ein MR-Element mit drei magnetisierbaren Schichten beschrieben, das eine so genannte magnetische Diode bildet. Durch Umschaltung der Magnetisierungsrichtung einer der Teilschichten kann eine logische Funktion invertiert werden (z. B. AND zu NAND), so dass beschränkt eine Funktionsauswahl (Negation) möglich ist. Eine frei programmierbare Logikschaltung, die auch ein Umschalten zwischen verschiedenen Grundoperationen (z. B. AND zu OR) erfordert, ist mit der Logikeinrichtung gemäß DE 100 36 356 jedoch nicht realisierbar. In DE 100 44 395 C1 wird ein Baustein für eine programmierbare magnetische Logik vorgeschlagen, der zwei MR-Elemente jeweils mit einer magnetischen Informationsschicht und einer magnetischen Referenzschicht aufweist. Die Anwendung dieses Bausteins ist auf die Erzeugung zweier Ausgangssignale beschränkt, die zueinander invertiert sind.

In der o. g. Publikation von W. C. Black et al. wird eine feldprogrammierte magnetische Logikschaltung beschrieben, die mehrere MR-Elemente und zugeordnete MR-Referenzelemente umfasst. Um ein Logikgrundelement zu bilden, werden mindestens drei MR-Elemente benötigt. Welche logische Funktion das Logikgrundelement ausführt, wird durch eine Einstellung an einem MR-Element und seinem zugeordneten MR-Referenzelement definiert. Der Nachteil dieser herkömmlichen Logikschaltung besteht im hohen Schaltungsaufwand. Des Weiteren ist zur Funktionsprogrammierung das Umschalten von mindestens zwei MR-Elementen erforderlich.

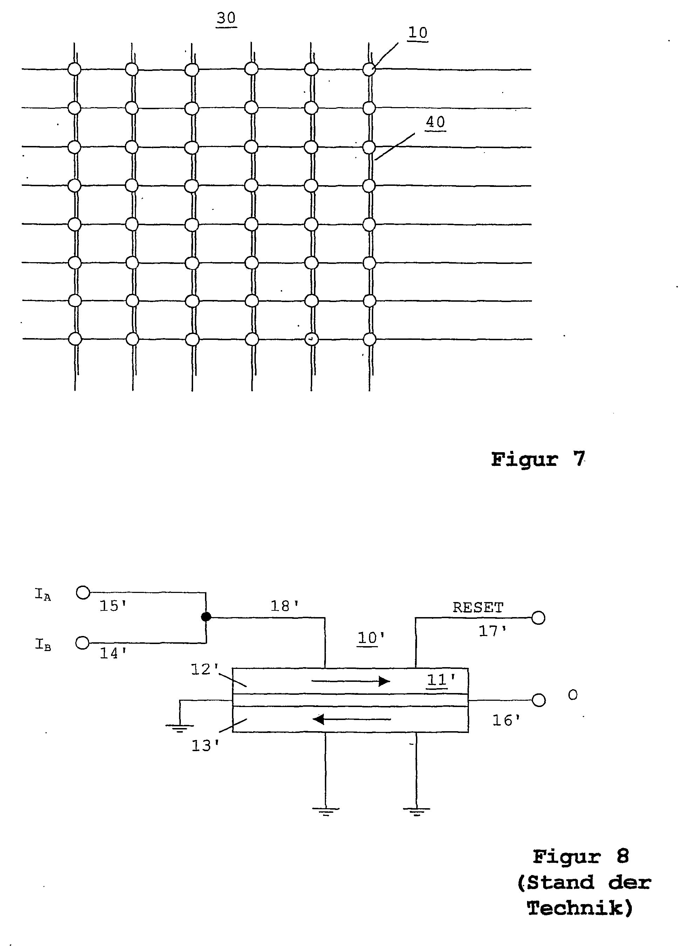

Von W. C. Black et al. wird in der genannten Publikation des weiteren die Logikfunktion eines einzelnen MR-Elements erläutert, das schematisch in Figur 8 illustriert ist. Die herkömmliche Logikeinrichtung 10' umfasst ein MR-Element 11' mit magnetisierbaren Schichten (Stellelementen) 12', 13', zwei Eingangsleitungen 14', 15', einer Ausgangsleitung 16' und einer RESET-Leitung 17'. Die Eingangsleitungen 14', 15' sind zu einer gemeinsamen Signalleitung 18' verbunden, mit der das MR-Element 11' magnetisierbar ist. Mit der Logikeinrichtung 10' wird eine logische OR-Operation wie folgt ausgeführt.

Zunächst erfolgt ein Rücksetzen des MR-Elements 11', indem die RESET-Leitung 17' mit einem vorbestimmten RESET-Strom beaufschlagt wird. Die Stellelemente 12', 13' werden dadurch beispielsweise mit antiparallelen Magnetisierungen magnetisiert (siehe Pfeile). Entsprechend ist der Widerstand des MR-Elements 11' zunächst hoch, so dass das logische Ausgangssignal O einer logischen "0" entspricht. Wenn an mindestens einer oder beiden der Eingangsleitungen 14', 15' ein logisches "1"-Signal anliegt (Eingangsstrom: Ein), wird eine der Schichten (z. B. 12') ummagnetisiert, während die andere Schicht ihre Magnetisierung beibehält. Im Ergebnis verringert sich der Widerstand des MR-Elements, und es ergibt sich ein Ausgangssignal "1" (OR-Funktion). Die entsprechende NOR-Funktion kann durch Umkehrung der Magnetisierung der anderen Schicht (hier: 13') erzielt werden.

Nachteilig an der Logikeinrichtung 10' mit dem einzelnen MR-Element ist die Beschränkung auf eine bestimmte Logikfunktion. Um nicht die OR-, sondern die AND-Funktion zu realisieren, müssen andere Signalströme eingestellt oder andere magnetische Materialien verwendet werden.

Ein wesentlicher Nachteil der Logikeinrichtung 10' besteht ferner darin, dass vor jeder logischen Operation das MR-Element durch den RESET-Schritt in den vorgegebenen Ausgangszustand gebracht werden muss. Der RESET-Schritt dient allein der Einstellung des Ausgangszustandes und stellt dadurch einen zusätzlichen Schalt- und Zeitaufwand dar, der zu der eigentlichen logischen Operation nicht beiträgt.

In DE 100 53 206 C1 ist eine frei programmierbare Logikeinrichtung ebenfalls mit einem einzelnen MR-Element beschrieben, das als magnetische Stellelemente zwei magnetische Schichten enthält. Die Stellelemente sind analog zu Figur 8 durch Beaufschlagung eines elektrischen Leiters mit Signalströmen, die für logische Eingangsgrößen charakteristisch sind, einzeln oder gemeinsam magnetisierbar. Je nach der gegebenen Magnetisierung ergibt sich ein bestimmter elektrischer Widerstand des MR-Elements, der als logische Ausgangsgröße weiterverarbeitet werden kann. Mit der Logikeinrichtung gemäß DE 100 53 206 C1 kann entweder die Logikfunktion AND/NAND oder die Logikfunktion OR/NOR realisiert werden. Um zwischen beiden Logikfunktionen umzuschalten, ist ein zusätzliches magnetisches Feld vorgesehen, das senkrecht zu den Schichten des MR-Elements ausgerichtet ist und mit dem die Koerzitivfeldstärke mit einem sogenannten Asteroid-Schaltverhalten verändert werden kann. Je nachdem, ob das senkrechte Magnetfeld anliegt oder nicht, ändert sich die logische Funktion der Logikeinrichtung. Ein Nachteil besteht darin, dass eine zusätzliche Magnetisierungseinrichtung zur Erzeugung des senkrechten Magnetfeldes vorgesehen sein muss. Weitere Nachteile bestehen in Beschränkungen in Bezug auf die Auswahl des Materials, der physikalischen Eigenschaften, der Geometrie und der Dimensionen der Stellelemente, um das in DE 100 53 206 C1 notwendig geforderte Asteroid-Schaltverhalten zu erzielen. Des Weiteren ist auch bei der Logikeinrichtung gemäß DE 100 53 206 C1 vor jeder logischen Operation zunächst der zusätzliche RESET-Schritt vorgesehen.

Die herkömmlichen magnetischen Logikeinrichtungen sind somit generell durch die folgenden Nachteile gekennzeichnet. Bei den herkömmlichen magnetischen Logikeinrichtungen werden nicht alle physikalischen Eigenschaften (z. B. Magnetismus, Symmetrie) für das Logikverhalten der MR-Elemente genutzt. Der Aufbau und die Arbeitsweise herkömmlicher magnetischer Logikeinrichtungen sind daher übermäßig aufwendig und kompliziert. Die bekannten magnetischen Logikeinrichtungen sind jeweils für eine bestimmte Logikfunktion ausgelegt oder nur durch aufwendige Maßnahmen, wie z. B. das Anlegen eines zusätzlichen, senkrechten Magnetfeldes oder die Einstellung veränderter Stromwerte auf eine andere Logikfunktion umschaltbar. Dieses Problem verschärft sich noch, wenn eine Vielzahl von Logikeinrichtungen in einer Logikschaltung integriert werden soll. Die selektive Programmierung von Logikeinrichtungen ist nur beschränkt und mit großem Schalt- und Zeitaufwand möglich. Echte magnetische frei programmierbare Logikschaltungen sind daher bisher nicht verfügbar. Eine Lösung könnte zwar darin gesehen werden, dass innerhalb einer integrierten Schaltung mehrere Gruppen von Logikeinrichtungen jeweils für eine Logikfunktion vorgesehen und bei Bedarf verwendet werden. Dies bedeutet jedoch keine Funktionsprogrammierung, sondern nur eine Auswahl unter Bauelementen mit fest eingestellten Funktionen. Es ergibt sich eine hohe Redundanz und ein Verlust an nutzbarer Integrationsdichte. Mit den herkömmlichen Verfahren, die analog zu den entsprechenden Techniken mit nichtmagnetischen Schaltungsanordnungen durchgeführt werden, ist eine Erhöhung der Integrationsdichte nur durch eine Verkleinerung der Strukturen zu erreichen. Ein zweiter genereller Nachteil ist die oben genannte RESET-Funktion, durch die Logikoperationen und damit der Betrieb von Logikschaltungen mit einer Vielzahl von einzelnen Logikeinrichtungen verlangsamt wird.

R. Richter et al. beschreiben in "Solid-State Electronics", Bd. 46, 2002, S. 639-643 eine frei programmierbare Logikeinrichtung mit magnetoresistiven Elementen. Eine Schaltung zur Ausführung einer Logikfunktion umfasst bei dieser Technik vier magnetoresistive Elemente, von denen zwei Elemente zur Auswahl einer logischen Operation und zwei Elemente zur Durchführung der logischen Operation vorgesehen sind.

Die Aufgabe der Erfindung ist, verbesserte Verfahren zum Betrieb von Logikeinrichtungen bereitzustellen, mit denen die Nachteile der herkömmlichen Techniken überwunden werden. Erfindungsgemäße Verfahren sollen insbesondere eine freie Programmierbarkeit einzelner magnetischer Elemente (magnetischer Komponenten) für die verschiedenen Logikfunktionen ermöglichen, den Ablauf von Logikoperationen beschleunigen und mit einem geringen schaltungstechnischen Aufwand realisierbar sein. Es soll insbesondere die Integrationsfähigkeit im Rahmen integrierter Logikschaltungen erleichtert werden. Die Aufgabe

der Erfindung ist es auch, eine verbesserte Logikeinrichtung bereitzustellen, mit der die Nachteile herkömmlicher Logikeinrichtungen überwunden werden und die sich insbesondere durch eine freie Programmierbarkeit und einen einfachen Aufbau mit verminderten Beschränkungen in Bezug auf die Materialien, die Geometrie und die Dimension von magnetischen Bauelementen auszeichnet.

Diese Aufgaben werden durch Verfahren und Logikeinrichtungen mit den Merkmalen gemäß den Patentansprüchen 1 oder 8 gelöst. Vorteilhafte Ausführungsformen und Anwendungen ergeben sich aus den abhängigen Ansprüchen.

Eine Grundidee der Erfindung ist es, ein Verfahren zum Betrieb einer magnetischen Logikeinrichtung, bei dem mindestens eine logische Operation durchgeführt wird, bei der aus logischen Eingangsgrößen (I_{A}, I_{B}) mit einer logischen Operatorfunktion F mindestens eine logische Ausgangsgröße O = F (I_{A}, I_{B}) gebildet wird, dahingehend weiter zu entwickeln, dass die Logikeinrichtung vor der Operation mit einem bestimmten Operator-Steuersignal (SET) auf einen Startzustand zur Ausführung der Operatorfunktion F eingestellt wird, wobei das Operator-Steuersignal aus einer Gruppe von verschiedenen Steuersignalen ausgewählt wird, mit denen verschiedene nichtflüchtige Startzustände der Logikeinrichtung gezielt einstellbar sind, die jeweils für bestimmte logische Funktionen charakteristisch sind.

Das erfindungsgemäße Verfahren wurde auf der Grundlage der folgenden Überlegungen der Erfinder entwickelt. Die Erfinder haben festgestellt, dass bei magnetoresistiven Elementen (MR-Elementen) mit zwei magnetischen Schichten, mit denen vier magnetisch unterscheidbare, nicht flüchtige Zustände realisierbar sind, bisher immer nur ein bestimmter Zustand als Ausgangspunkt zur Realisierung einer Logikfunktion verwendet wird. Auf diesen vorgegebenen Zustand wurde die Logikeinrichtung beim RESET-Schritt rückgesetzt. Hierzu im Gegensatz werden erfindungsgemäß alle magnetisch unterscheidbaren Zustände der Logikeinrichtung als frei wählbare Startzustände für ausführbare Logikoperationen verwendet. Die Einstellung des aktuellen Zustandes und damit der aktuell gewünschten Logikfunktion (Operatorfunktion F) als eine Auswahl verschiedener nichtflüchtiger Zustände aus dieser Gruppe erfolgt mit dem Operator-Steuersignal. Wenn im Zeitverlauf verschiedene Logikfunktionen ausgeführt werden sollen, wird eine Logikeinrichtung entsprechend aufeinander folgend mit verschiedenen Operator-Steuersignalen eingestellt.

Erfindungsgemäß wird insbesondere vorgeschlagen, magnetische Logikeinrichtungen mit einem einzelnen magnetischen Element, insbesondere einem einzelnen MR-Element sequentiell wie folgt zu betreiben. Zuerst erfolgt eine gezielte Einstellung oder Funktionsprogrammierung der Logikeinrichtung durch eine Auswahl des Operator-Steuersignals aus der Gruppe verschiedener Steuersignale, mit denen verschiedene nichtflüchtige Startzustände einstellbar sind, die jeweils für verschiedene logische Funktionen charakteristisch sind (d. h. zur Auswahl der gewünschten Operatorfunktion aus der Gruppe verschiedener logischer Funktionen) und ein Setzen (SET) der Logikeinrichtung durch Beaufschlagung des magnetischen Elements mit dem ausgewählten Operator-Steuersignal. Mit dem Operator-Steuersignal wird die Logikeinrichtung entsprechend einer der möglichen nicht flüchtigen Konfigurationen eingestellt. Die Funktionsprogrammierung ersetzt verschiedene Vorgänge, die bei den herkömmlichen Logikeinrichtungen getrennt und mit großem Aufwand ausgeführt wurden, nämlich die hardwaretechnische Auswahl der Logikfunktion einerseits und den softwaremäßigen RESET-Schritt andererseits.

Das erfindungsgemäße Verfahren stellt auch gegenüber dem herkömmlichen Betrieb nichtmagnetischer Schaltungsanordnungen einen wesentlichen Unterschied dar. Bei nichtmagnetischen FPGA-Schaltungen ist die Zwischenspeicherung der Funktionsprogrammierung und der entsprechende Zyklusbetrieb nicht oder nur für begrenzte Zeit (Haltbarkeit der Speicherschicht) möglich.

Ein wesentlicher Vorteil der Erfindung besteht darin, dass die Logikeinrichtungen in Logikschaltungen integriert werden können und die in einer integrierten Logikschaltung enthaltenen Logikeinrichtungen (individuelle Logikgrundelemente) durch die sequentielle Funktionsprogrammierung mit erhöhter Effektivität genutzt werden können. Während bei herkömmlichen Logikschaltungen in der Regel vier Gruppen von Logikeinrichtungen enthalten waren, die jeweils für eine bestimmte Logikfunktion ausgelegt waren, können bei einer erfindungsgemäß betriebenen Logikschaltungen alle Logikeinrichtungen wahlweise für alle aktuell gewünschten Logikfunktionen verwendet werden. Somit kann mit weniger Logikeinrichtungen (in der Regel: Faktor 4) die Funktionsfähigkeit einer Logikschaltung voll erhalten bleiben.

Gemäß der Erfindung wird das Operator-Steuersignal aus einer Gruppe von verschiedenen Steuersignalen ausgewählt, um gezielt Startzustände der Logikeinrichtung einzustellen, die jeweils für eine logische Funktion aus der Gruppe der logischen AND-, OR-, NAND- und NOR-Funktionen charakteristisch sind. Diese Ausführungsform kann in Bezug auf die Flexibilität der Funktionsausführung Vorteile haben, da alle vier, in der Praxis interessierenden logischen Grundfunktionen einstellbar sind.

Wenn die Steuersignale Steuerstromsignale umfassen, unter deren Wirkung Magnetfelder erzeugt werden, durch die im magnetoresistiven Element die jeweilige logische Funktion eingestellt wird, können sich weitere Vorteile in Bezug auf die Umsetzung des erfindungsgemäßen Verfahrens mit verfügbaren Strukturen magnetischer Bauelemente ergeben. Besonders vorteilhaft ist es, wenn die Steuerstromsignale über Eingangsleitungen zur Eingabe der Eingangsgrößen (I_{A}, I_{B}) der Logikeinrichtung zugeführt werden. Bei dieser Gestaltung vereinfacht sich der Aufbau einer Logikschaltung mit einer Vielzahl integrierter Logikeinrichtungen. Die Steuerstromsignale können darüber hinaus konstante Strombeträge aufweisen. Dies stellt einen erheblichen Vorteil gegenüber herkömmlichen Techniken (siehe W. C. Black et al.) dar, bei denen gegebenenfalls zur Umschaltung der Logikfunktion verschiedene Strombeträge eingespeist werden müssen. Alternativ können die Steuersignale Schaltsignale zur Ummagnetisierung der jeweils betroffenen magnetoresistiven Elemente durch strominduziertes Schalten umfassen. In diesem Fall können sich Vorteile aus dem direkten, strominduzierten Schalten der Magnetisierungsrichtung ergeben.

Die Steuerstromsignale können durch kontinuierliche, geschaltete Ströme gebildet werden, mit denen das magnotoresistive Element beaufschlagt wird. Vorteilhafterweise kann sich jedoch eine weitere Verbesserung der Kompatibilität mit den in der Praxis verwendeten elektronischen Schaltkreisen und eine Verringerung des Energieverbrauches und damit der Wärmeentwicklung ergeben, wenn die Steuerstromsignale getaktete oder gepulste Ströme umfassen.

Typischerweise wird die Logikeinrichtung zur Eingabe der logischen Eingangsgrößen (I_{A}, I_{B}) mit Eingangsstromsignalen beaufschlagt. Die Eingangsstromsignale werden vorzugsweise so gebildet, dass sie die gleichen Beträge wie die Steuerstromsignale aufweisen.

Die Erfindung kann allgemein mit allen magnetischen Logikeinrichtungen ausgeführt werden, die ein einzelnes magnetoresistives Element mit mehreren, magnetisch unterscheidbaren, nicht flüchtigen Zuständen enthalten. So besitzt ein magnetoresistives Element mindestens zwei magnetische Stellelemente mit verschiedenen Koerzitivfeldstärken, an denen mit dem Operator-Steuersignal einer von mindestens zwei Startzuständen einstellbar ist. Gemäß der Erfindung sind die Koerzitivfeldstärken und die Strombeträge der Stromsignale so abgestimmt, dass beide Stellelemente durch das Operator-Steuersignal verstellt werden können. Dadurch sind mit zwei Stellelementen vorteilhafterweise alle vier möglichen Konfigurationen von Magnetisierungsrichtungen realisierbar. In diesem Modus sind beide Stellelemente frei verstellbar ("unpinned"). Alternativ ist die Koerzitivfeldstärke von einem der Stellelemente so hoch gewählt, dass es mit den Stromsignalen nicht verstellt werden kann (Modus: "pinned") wobei dies keine Ausführungsform der Erfindung darstellt. In diesem Fall sind nur zwei Konfigurationen von Magnetisierungseinstellungen als Startzustand und damit nur zwei Logikfunktionen realisierbar. Es können sich aber Vorteile in Bezug auf die Einfachheit des Aufbaus der Logikeinrichtung ergeben.

Ein weiterer Gegenstand der Erfindung ist ein Verfahren zum Betrieb einer magnetischen Logikschaltung, die eine Vielzahl von Logikeinrichtungen umfasst, mit denen gleichzeitig oder aufeinander folgend eine Vielzahl logischer Operationen nach den oben beschriebenen Verfahren ausgeführt werden.

Vorteilhafterweise kann jede Logikeinrichtung gemäß einem vorgegebenen Arbeitstakt laufend und aufeinander folgend gleiche oder verschiedene logische Operationen ausführen. Damit kann Redundanz vermieden und die Effektivität der Logikschaltung erheblich gesteigert werden.

Ein weiterer Gegenstand der Erfindung ist eine magnetische Logikeinrichtung mit einem logischen magnetoresistiven Element, mindestens zwei Eingängen und mindestens einem Ausgang, die zur Ausführung mindestens einer logischen Operation eingerichtet ist, bei der aus Eingangsgrößen (I_{A}, I_{B}) mit einer Operatorfunktion F mindestens eine Ausgangsgröße O = F (I_{A}, I_{B}) gebildet wird, wobei das magnatoresistive Element mit einer Steuerschaltung zur Erzeugung eines bestimmten Operator-Steuersignals zur Ausführung der Operatorfunktion F aus einer Gruppe verschiedener Steuersignale, die jeweils für verschiedene logische Funktionen charakteristisch sind, verbunden ist.

Gemäß der Erfindung weist die Steuerschaltung eine Stromquelle zur Erzeugung verschiedener Stromsteuersignale entsprechend verschiedenen logischen Funktionen und eine Schalteinrichtung auf, mit der eines der Stromsteuersignale als Operator-Steuersignal an das magnetoresistive Element gegeben werden kann.

Die Schalteinrichtung kann beispielsweise programmgesteuert arbeiten. Weitere Vorteile können sich ergeben, wenn die Steuerschaltung einen Operatorfunktions-Wähler aufweist, mit dem die Schalteinrichtung verbunden ist.

Gemäß der Erfindung umfasst die Logikeinrichtung ein magnetoresistives Element (MR-Element). Es können sich Vorteile dahingehend ergeben, dass magnetoresistive Elemente an sich verfügbar und in ihrer Verwendung gut handhabbar sind. Die Umsetzung der Erfindung ist generell auch mit magnetoresistiven Elementen realisierbar, deren relative Orientierung z. B. mit optischen oder magnetostriktiven Elementen detektierbar ist.

Wesentliche Vorteile erfindungsgemäßer Logikeinrichtungen bestehen darin, dass sie 1. universell einsetzbar, d.h. als Logik- oder als Speicherelemente verwendbar sind, 2. frei programmierbar sind, also jeweils gewünschte Logikfunktionen eingestellt werden können, und 3. nicht flüchtig sind (Informationen und Logikfunktionen bleiben erhalten). Des Weiteren zeichnen sie sich durch eine maximale Einfachheit im Aufbau aus. Beschränkungen auf bestimmte Materialien oder Geometrien können vermieden werden.

Weitere Vorteile und Einzelheiten der Erfindung werden aus der folgenden Beschreibung der beigefügten Zeichnungen ersichtlich. Es zeigen:
- Fig. 1:: eine schematische Darstellung einer erfindungsgemäßen Logikeinrichtung,
- Fig. 2:: ein Flussdiagramm zur Illustration des erfindungsgemäßen Verfahrens,
- Fig. 3:: eine perspektivische Ansicht einer ersten Ausführungsform eines erfindungsgemäß verwendeten MR-Elements,
- Fig. 4:: eine tabellarische Zusammenfassung der vier magnetischen Startzustände des MR-Elements und der zugehörigen logischen Funktionen,
- Fig. 5:: Beispiele für Taktsequenzen beim Betrieb erfindungsgemäßer Logikeinrichtungen,
- Fig. 6:: eine perspektivische Ansicht eines weiteren MR-Elements (keine Ausführungsform der Erfindung) ,
- Fig. 7:: eine schematische Darstellung einer erfindungsgemäßen Logikschaltung mit einer Vielzahl von Logikeinrichtungen, und
- Fig. 8:: eine schematische Darstellung einer herkömmlichen Logikeinrichtung (Stand der Technik).

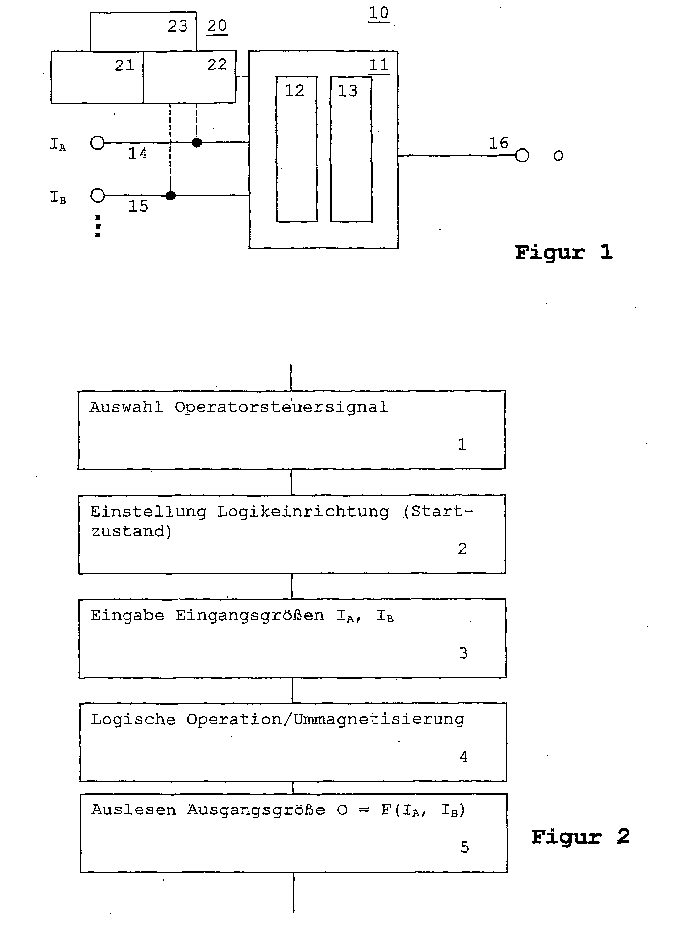

Die Umsetzung der Erfindung wird im Folgenden nach einer allgemeinen Darstellung gemäß Figur 1 unter beispielhaften Bezug auf die Verwendung von magnetoresistiven Dünnschichtbauelementen beschrieben. Es wird jedoch betont, dass die Verwendung von MR-Dünnschichtbauelementen nicht zwingend erforderlich ist. Vielmehr kann das erfindungsgemäße Verfahren generell mit magnatoresistiven Bauelementen realisiert werden, die die Nutzung verschiedener magnetisch unterscheidbarer Startzustände als Logikfunktionen zulassen. Des weiteren ist die Erfindung nicht zwingend auf magnetische Bauelemente mit 2 Eingängen und 1 Ausgang beschränkt, sondern entsprechend auch mit mehr Ein- oder Ausgängen umsetzbar.

Die Gruppe der erfindungsgemäß verwendbaren magnetischen Elemente umfasst insbesondere solche MR-Elemente, die auf der Grundlage der Magnetowiderstandseffekte AMR (anisotropic magnetoresistance), GMR (giant magnetoresistance), TMR (tunneling magnetoresistance), CMR (colossal magnetoresistance) und GMI (giant magnetoimpedance) beruhen (siehe Broschüre "XMR-Technologien"-Technologieanalyse: Magnetismus, Band 2, VDI-Technologiezentrum "Physikalische Technologien", Düsseldorf, Deutschland, 1997, S. 11 - 46).

Die Parameter der MR-Elemente, wie z. B. die Materialien, Dicken, Geometrien, Stromstärken etc. werden gewählt, wie es an sich von herkömmlichen Anwendungen von MR-Elementen bekannt ist.

Schließlich wird betont, dass die Umsetzung der Erfindung nicht auf die im folgenden beispielhaft genannten logischen Funktionen beschränkt ist, sondern entsprechend mit davon abgeleiteten logischen Funktionen oder arithmetischen Funktionen oder anderen logischen Funktionen, wie zum Beispiel Komplementbildungen, bitbezogenen Abfragen, Vergleichen, Invertierungen etc. anwendbar ist.

Figur 1 zeigt schematisch eine erfindungsgemäße Logikeinrichtung 10 mit einem magnetoresistiven Bauelement 11 (MR-Element 11), das zwei magnetische Stellelemente 12, 13 jeweils mit zwei magnetisch unterscheidbaren Zuständen aufweist, und einer Steuerschaltung 20. Die Stellelemente 12, 13 des MR-Elements 11 bestehen aus magnetischen Materialien, von denen das eine Material magnetisch weicher als das andere Material ist. Die magnetischen Zustände unterscheiden sich durch die jeweiligen Magnetisierungsrichtungen der Stellelemente 12, 13. Die Logikeinrichtung 10 umfasst mindestens zwei Eingänge 14, 15 und mindestens einen Ausgang 16, die zur Eingabe und Ausgabe logischer Eingangs- und Ausgangsgrößen am MR-Element 11 eingerichtet sind. Die Eingänge 14, 15 sind mit mindestens einem elektrischen Signal-Leiter verbunden, mit dem bei Beaufschlagung mit einem elektrischen Signalstrom ein Magnetfeld induziert wird, durch das die Magnetisierungsrichtung mindestens eines der Stellelemente 12, 13 veränderlich ist. Der Ausgang 16 ist Teil eines Stromkreises (nicht dargestellt), in dem der elektrische Widerstand des MR-Elements 11 in an sich bekannter Weise messbar ist. Es wird betont, dass die logische Ausgangsgrö-βe O = F(I_{A}, I_{B}) alternativ durch andere Messverfahren detektiert werden kann, die geeignet sind, zwischen paralleler und antiparalleler Konfiguration der beiden magnetischen Stellelemente zu unterscheiden, z. B. bei optischen oder magnetostriktiven Verfahren

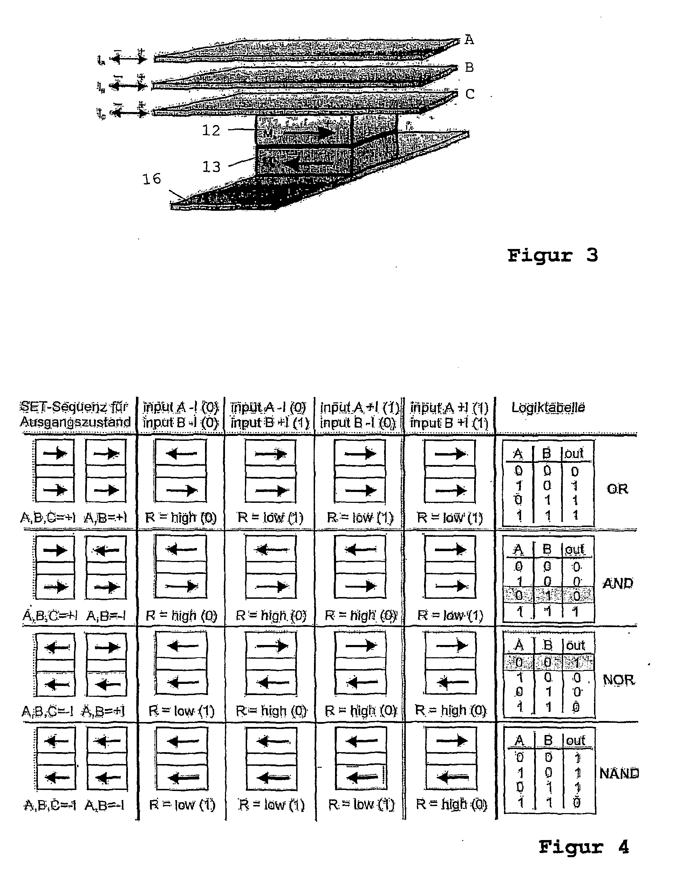

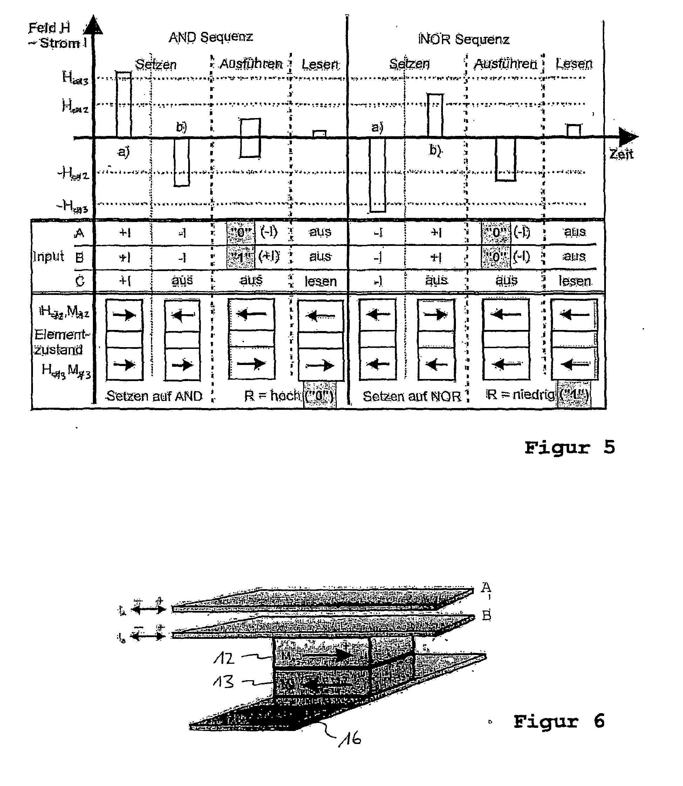

Die Steuerschaltung 20 dient der Erzeugung des Operator-Steuersignals und umfasst beispielsweise eine Stromquelle 21, eine Schalteinrichtung 22 und gegebenenfalls einen Operatorfunktions-Wähler 23. Die Stromquelle 21 ist über die Schalteinrichtung 22 mit mindestens einem elektrischen Leiter verbunden, mit dem die Magnetisierungsrichtung mindestens eines der Stellelemente 12, 13 veränderlich ist. Dieser Leiter kann als eigenständiges Bauteil vorgesehen sein, ist aber vorzugsweise mit dem mindestens einen Signal-Leiter der Eingänge 14, 15 kombiniert. Einzelheiten der Verknüpfung der Steuerschaltung 20, der Eingänge 14, 15 und des Ausgangs 16 mit dem MR-Element 11 sind beispielhaft in den Figuren 3 und 6 gezeigt (siehe unten).

Wesentliche Schritte des erfindungsgemäßen Verfahrens sind in Figur 2 illustriert. Figur 2 zeigt einen Ausschnitt des Funktionsablaufs beim Betrieb einer Logikeinrichtung, der die Ausführung der logischen Funktion betrifft. Weitere Einzelheiten des Funktionsablaufs sind an sich von herkömmlichen FPGA-Schaltungen bekannt und werden daher hier nicht beschrieben. Gemäß Figur 2 erfolgt zuerst die Auswahl des Operator-Steuersignals SET, das für die Ausführung einer bestimmten logischen Funktion charakteristisch ist (Schritt 1). Das Operator-Steuersignal SET wird aus einer Gruppe verschiedener Steuersignale ausgewählt, die jeweils für verschiedene logische Funktionen charakteristisch sind. Die Auswahl erfolgt durch eine entsprechende Eingabe an die Steuerschaltung 20, z. B. durch ein Steuerprogramm oder mit dem Operatorfunktions-Wähler 23. Die Möglichkeit einer softwarebasierten Auswahl der Logikfunktion stellt einen wesentlichen Vorteil der Erfindung dar. Bei Schritt 2 wird die Steuerschaltung 20 mit dem aktuell gewählten Operator-Steuersignal SET beaufschlagt, so dass ein Startzustand entsprechend der gewünschten Operatorfunktion F eingestellt wird. Mit dem Operator-Steuersignal SET werden die Magnetisierungen der Stellelemente 12, 13 in zwei Teilschritten beispielsweise parallel oder antiparallel eingestellt, um den Startzustand für die nachfolgende logische Operation (Schritte 3, 4) zu bilden.

Hierzu werden die Eingänge 14, 15 mit den Eingangsgrößen (I_{A}, I_{B}) beaufschlagt (Schritt 3), so dass sich die Magnetisierungen der Stellelemente 12, 13 in charakteristischer Weise einstellen. Die Eingangsgrößen werden beispielsweise durch Stromsignale gebildet, die je nach ihrer Stromrichtung eine logische "1" oder "0" repräsentieren. Die Stromsignale können zu einer Erhaltung des Startzustandes oder zu einer Ummagnetisierung mindestens eines der Stellelemente 12, 13 führen (Schritt 4). Im Ergebnis ist die Konfiguration der beiden Stellelemente 12, 13 erhalten geblieben oder verändert. Am MR-Element (11) wird für den aktuellen Widerstand eine charakteristische Spannungs- oder Stromgröße am Ausgang 16 ausgelesen (Schritt 5). Die Ausgangsgröße O ist vom Startzustand, der durch die Operatorfunktion F bestimmt ist, und den Eingangsgrößen (I_{A}, I_{B}) abhängig: O = F (I_{A}, I_{B}). Erfindungsgemäß können eine Vielzahl von logischen Operationen in Folge durchgeführt werden, wobei der Ablauf gemäß Figur 2 entsprechend mehrfach durchlaufen wird. Die Schritte 1 und 2 können insbesondere dann modifiziert sein, wenn ein Endzustand des magnetischen Elements nach einer logischen Operation gerade dem gewünschten Startzustand für die folgende logische Operation entspricht. In diesem Fall kann auf Schritt 2 verzichtet werden, da die Einstellung des magnetischen Elements durch die vorhergehende logische Operation erfolgt ist.

Eine erfindungsgemäß verwendbare Verknüpfung des MR-Elements 11 mit den Eingängen 14, 15 und dem Ausgang 16 ist beispielhaft in Figur 3 dargestellt. Als MR-Element ist ein GMR-Element mit zwei magnetischen Schichten 12 und 13 mit den jeweiligen Magnetisierungen M₁₂ und M₁₃ und den dazugehörigen Koerzitivfeldstärken H_{c12} und H_{c13} vorgesehen, wobei im gewählten Beispiel H_{c12} kleiner als H_{c13} ist. Die Reihenfolge der Schichten mit verschiedenen Koerzitivfeldstärken kann bei einer abgewandelten Gestaltung umgekehrt sein. Die Schichten 12 und 13 sind voneinander magnetisch isoliert, wie es von herkömmlichen MR-Elementen bekannt ist. Der am Ausgang 16 als Ausgangsgröße 0 (Output) abgreifbare Spannungsabfall (Messspannung) ist von der relativen Ausrichtung der beiden Magnetisierungen zueinander abhängig.

Das GMR-Element 12, 13 wird durch drei Signal-Leiter A, B und C (Input) bestromt, die mit den Eingängen 14, 15 und der Steuerschaltung 20 verbunden sind. Die drei unabhängigen Signal-Leiter A, B und C sind voneinander elektrisch isoliert und werden mit den jeweiligen Strömen I_{A}, I_{B} und I_{C} beaufschlagt, deren Beträge zweckmäßigerweise gleich sein können. Die dadurch erzeugten Magnetfelder H_{A}, H_{B} und H_{C} überlagern sich und dienen erfindungsgemäß sowohl als SET-Funktion als auch als logisches Eingangssignal. Die Signal-Leiter A, B und C sind in Figur 3 nur aus Übersichtlichkeitsgründen mit Abstand gezeichnet. In der Praxis können sie sich berühren oder sogar durch einen gemeinsamen Signal-Leiter mit Anschlüssen für die Eingänge 14, 15 und die Steuerschaltung 20 gebildet werden.

Für das in den Figuren 4, 5 dargestellte Schema sind die Verhältnisse zwischen den von den Signal-Leitern erzeugten Magnetfeldern H_{A}, H_{B} und H_{C} und den Koerzitivfeldstärken H_{c12} und H_{c13} wie folgt: jedes Feld H_{A}, H_{B} und H_{C} für sich ist kleiner als H_{c12}, die Summe H_{A} + H_{B} sei größer als H_{c12} aber kleiner als H_{c13}, die Summe H_{A} + H_{B} + H_{C} sei größer als H_{c13}. Somit wird erreicht, das kein Strom für sich eine der beiden Magnetisierungen drehen kann. Die Ströme der Signal-Leiter A und B drehen nur gemeinsam die Magnetisierung von Schicht 12, während die Magnetisierung von Schicht 13 nur durch alle drei Eingangsströme zusammen gedreht werden kann. Dies gilt nur für jeweils gleichsinnige Ströme; gegensinnige Ströme annullieren sich gegenseitig.

Die mit den Stromrichtungen repräsentierten logischen Eingangsgrößen werden z. B. durch die Stromsignale I_{A}, I_{B} gebildet. Die jeweilige Stromrichtung +I wird mit der durch sie bevorzugten Magnetisierungsrichtung +M identifiziert, die im Folgenden durch Pfeile nach rechts versinnbildlicht werden (s. Figur 3). Diese Stromrichtung (+I) wird mit einer logischen "1", die entgegengesetzte Stromrichtung (-I) wird mit einer logischen "0" identifiziert. Des weiteren stellt ein hoher Magnetowiderstand (Magnetisierungen antiparallel) eine logische "0" als Output dar, ein niedriger (Magnetisierungen parallel) eine logische "1". Diese globalen Festlegungen definieren das Schaltverhalten der Logikeinrichtung. Die Bestromung kann in kurzen, getakteten Pulsen (Dauer je nach Anwendung z. B. im fs- bis ms-Bereich, Frequenz z. B. im GHzbis kHz-Bereich) erfolgen, so dass der Energieverbrauch und damit die Erwärmung des Elements kleinstmöglich gehalten werden kann.

Durch die erfindungsgemäße, gezielte Bestromung der drei Signal-Leiter lassen sich bei Schritt 2 (Figur 2) die vier prinzipiell möglichen, magnetisch unterscheidbaren Konfigurationen eines einzelnen GMR-Elements als Startzustände definiert in zwei Teilschritten darstellen, wie es in Figur 4 schematisch zusammengefasst ist.

Die Beaufschlagung mit dem Operator-Steuersignal (SET-Sequenz) besteht aus zwei aufeinanderfolgenden Teilschritten. Zunächst wird durch gleichzeitige Bestromung aller drei Signal-Leiter A, B und C die Richtung der Magnetisierung der hartmagnetischeren Schicht 13 eingestellt: z. B. führt +I an allen Eingängen zu + M₁₃ (Schicht 12 stellt sich genauso ein). Anschließend wird durch gleichzeitiges Bestromen von A und B nur noch die weichmagnetischere Schicht 12 eingestellt, z. B. führt -I an den Eingängen A und B zu - M₁₂; M₁₃ wird nicht weiter beeinflusst. In der linken Spalte von Figur 4 sind die vier Varianten von möglichen Startzuständen gezeigt.

Die logische Operation (Schritte 3, 4, 5 in Figur 2) umfasst die folgende Eingabe der Eingangsgrößen. Zuerst werden die Eingänge 14 und 15 und entsprechend die Signal-Leiter A und B getrennt mit Stromsignalen beaufschlagt. Bei gleichsinnigen Strömen (Signal-Leiter A und B beide auf +I oder -I) beider Eingänge ist ein Drehen der Magnetisierung möglich. Anderfalls (gegensinnige Ströme) ist ein Drehen der Magnetisierung ausgeschlossen. Je nach der softwaremäßig gewählten SET-Sequenz erhält man daraus verschiedene Endzustände nach der logischen Operation. Wenn der Endzustand parallel ist, so ist der Magnetowiderstand niedrig und die Ausgangsgröße (Output) eine logische "1". Wenn der Endzustand antiparallel ist, so ist der Magnetowiderstand hoch und die Ausgangsgröße ist eine logische "0".

Die jeweils vier möglichen Ausgangsgrößen aus den vier verschiedenen Startzustände sind in den Logiktabellen in der rechten Spalte von Figur 4 zusammengefasst. Diese entsprechen den vier Logikfunktionen OR, AND, NOR und NAND. Die logische OR-Funktion (erste Zeile, Figur 4) ergibt sich beispielsweise wie folgt.

Zuerst wird die logische Funktion OR mittels der SET-Sequenz festgelegt. Im ersten Teilschritt wird Schicht 13 auf +M gelegt, indem an alle drei Signal-Leiter A, B und C +I angelegt wird. Anschließend wird Schicht 12 auf +M gelegt und damit OR definiert, indem die Signal-Leiter A und B mit +I bestromt werden. Nun liegen die Magnetisierungen parallel nach rechts und damit ist der Magnetowiderstand niedrig (logische "1"). Dann werden im zweiten Schritt die Signal-Leiter A und B getrennt bestromt, um die logische Operation auszuführen. Es ergeben sich die folgenden vier Möglichkeiten:
1. Werden beide Signal-Leiter auf "0" gesetzt, d. h. mit -I beaufschlagt, wird die Magnetisierung von Schicht 12 gedreht; die Magnetisierungen liegen nun antiparallel, der Magnetowiderstand ist hoch und damit der Output auf "0" (s. oberste Zeile in der Logiktabelle).
2. Wird Signal-Leiter A auf "0" und Signal-Leiter B auf "1" gesetzt, d.h. mit -I bzw. +I beaufschlagt, kompensieren sich die beiden Felder gerade und die durch die SET-Sequenz eingestellte Magnetisierung bleibt erhalten (Output "1").
3. Signal-Leiter A auf "1 " und Signal-Leiter B auf "0" ist äquivalent zu Fall 2 (Output "1").
4. Werden beide Signal-Leiter auf "1" gesetzt, d.h. mit +I beaufschlagt, stellt dies nur die Wiederholung des zweiten Teilschritts der SET-Sequenz dar, was die Schicht 12 nochmals auf +M setzt. Die Ausgangsgröße ist wiederum "1", da die beiden Magnetisierungen weiterhin parallel zueinander liegen.

Für alle Möglichkeiten 1 bis 4 bleibt die Magnetisierung des Stellelementes 13 erhalten. Vorteilhafterweise wird eine vollständige Logiktabelle bereitgestellt, die in diesem Falle die OR-Funktion darstellt.

Die erfindungsgemäße Abfolge der Beschaltung ist in Figur 5 am Beispiel einer logischen AND- mit anschließender NOR- Sequenz veranschaulicht, die den in Figur 4 markierten Logikfunktionen entsprechen.

Einer SET-Sequenz (Schritt 2 in Figur 2) aus zwei Teilschritten a) und b) folgt ein Schritt zum Ausführen der logischen Operation (Schritte 3, 4) und ein weiterer Schritt zum Auslesen der Ausgabe (Schritt 5). Der erste Teilschritt wählt über die Schicht 13 die Logik auf Nichtnegation (-M₁₃) oder Negation (+M₁₃) vor. Der zweite Teilschritt setzt die logische Operation auf OR (+M₁₂) oder AND (-M₁₂). Die anschließende Ausführung der logischen Operation kann ein.Wechsel der Magnetisierungsrichtung der Schicht 12 zur Folge haben (wie im zweiten gezeigten Fall) oder nicht (wie im ersten Fall). Der abschließende Leseschritt kann zweckmäßigerweise durch Beaufschlagung von einem der drei Signal-Leiter (im gezeigten Fall über Signal-Leiter C) mit einem Lesestrom erfolgen, der durch das MR-Element läuft und über die Ausgangsleitung 16 abgreifbar ist. Es besteht alternativ die Möglichkeit, das Auslesen analog zum Aufbau gemäß Figur 8 mit einem vom Signal-Leiter getrennten Stromkreis zu realisieren, in den die Ausgangsleitung 16 eingebunden ist.

Nach Ausführung der logischen Funktion ist vorteilhafterweise erfindungsgemäß kein gesonderter RESET erforderlich, da die nächsten zwei SET-Teilschritte das MR-Element wiederum in einen der vier definierten Zustände versetzen. Es können sich auch Vorteile daraus ergeben, dass abhängig von der Ausgabe der vorherigen Logikfunktion die nachfolgende Logikfunktion bereits vorgewählt ist und die SET-Sequenz eventuell entfallen kann.

Ein weiteres MR-Element (keine Ausführungsform der Erfindung) mit nur zwei Eingängen ist in Figur 6 illustriert. Wenn auf die dritte Signal-Leitung C verzichtet wird, kann die hartmagnetischere Schicht 13 nur über größere Ströme I_{A}/I_{B} ummagnetisiert werden. Trotzdem können analog zu den obigen Betrachtungen auch bei fester Magnetisierungsrichtung der Schicht 13 (Modus 'pinned') immer noch zwei logische Operationen (OR und AND) ausgeführt werden, wobei die SET-Sequenz nicht zwei Teilschritte, sondern nur einen Schritt umfasst, bei dem die Schicht 12 parallel (OR) oder antiparallel (AND) zur Schicht 13 eingestellt wird.

Ein wichtiger Vorteil der Erfindung kann in der Kompatibilität mit dem Betrieb von Speichereinrichtungen bestehen. Verzichtet man vollständig auf die logische Operation, so wird eine Schaltung bereitgestellt, die wie ein übliches MRAM-Speicherelement funktioniert.

Zusammenfassend ist festzuhalten, dass die Erfindung eine freiprogrammierbare Logikeinrichtung bereitstellt, die auf mindestens zwei magnetischen Stellelementen eines einzelnen MR-Elementes mit mindestens zwei Eingängen beruht. Mittels der erfindungsgemäßen Beschaltung der SET-Sequenz in zwei Teilschritten ist es möglich, sich vier grundlegende Logikfunktionen (OR, AND, NOR und NAND) mit einem einzigen Bauelement zugänglich zu machen, ohne das weitere Mittel wie Spannungen, magnetische Felder oder weitere MR-Elemente notwendig sind.

Figur 7 zeigt ausschnittsweise eine erfindungsgemäße Logikschaltung 30 mit einer Vielzahl von matrixartig angeordneten Logikeinrichtungen 10. Jede der Logikeinrichtungen 10 kann analog zu Figur 1 mit einer eigenen Steuerschaltung ausgestattet sein. Alternativ können mehrere oder alle Logikeinrichtungen 10 jeweils mit einer gemeinsamen Steuerschaltung verbunden sein. Die Logikeinrichtungen 10 sind vorzugsweise als integrierte Schaltung angeordnet und über ein Netzwerk 40 von Schreib- und Leseleitungen verknüpft, wie es an sich von herkömmlichen FGPA-Schaltungen oder MRAM-Arrays bekannt ist.

## Patentansprüche

1. Verfahren zum Betrieb einer magnetischen Logikeinrichtung (10), bei dem durch mindestens eine logische Operation aus Eingangsgrößen (I_{A}, I_{B}) mit einer Operatorfunktion F der magnetischen Logikeinrichtung (10) mindestens eine Ausgangsgröße O = F (I_{A}, I_{B}) gebildet wird, wobei
- die Logikeinrichtung (10) vor der Operation mit einem bestimmten Operator-Steuersignal (SET) auf einen Startzustand zur Ausführung der Operatorfunktion F eingestellt wird, wobei das Operator-Steuersignal aus einer Gruppe von Steuerstromsignalen ausgewählt wird, unter deren Wirkung verschiedene Startzustände gezielt einstellbar sind, die jeweils für verschiedene logische Funktionen charakteristisch sind,
- die magnetische Logikeinrichtung (10) ein einziges magnetoresistives Element (11) mit zwei magnetischen Stellelementen (12, 13) umfasst, die verschiedene Koerzitivfeldstärken aufweisen,
- zur Ausführung der Operatorfunktion F Eingänge (14, 15) der Stellelemente (12, 13) zur Eingabe der logischen Eingangsgrö-βen (I_{A}, I_{B}) mit Eingangsstromsignalen beaufschlagt werden, und
- die magnetischen Logikeinrichtung (10) mit einer Stromquelle (21) und einer Schalteinrichtung (22) verbunden ist,
**dadurch gekennzeichnet, dass**
- das Operator-Steuersignal mit der Stromquelle (21) erzeugt und mit der Schalteinrichtung (22) an die Eingänge (14, 15) der Stellelemente (12, 13) angelegt wird, und
- die Logikeinrichtung (10) mit dem Operator-Steuersignal SET auf einen nichtflüchtigen Logikzustand als Startzustand eingestellt wird, wobei
- an den zwei magnetischen Stellelemente mit den Steuerstromsignalen jeder von vier Startzuständen einstellbar ist, wobei mit den Steuerstromsignalen die Startzustände nichtflüchtig einstellbar sind, die jeweils für eine logische Funktion aus der Gruppe der logischen AND-, OR-, NAND- und NOR-Funktionen charakteristisch sind,
- die Koerzitivfeldstärken der Stellelemente (12, 13) und die Strombeträge der Steuerstromsignale so abgestimmt werden, dass die Magnetisierungsrichtungen von beiden Stellelementen (12, 13) durch das Operator-Steuersignal verstellt werden können, um den Startzustand für die Ausführung der Operatorfunktion F zu bilden, wobei die Steuerstromsignale aus drei Strömen (I_{A}, I_{B} und I_{C}) gebildet werden und die Magnetisierungsrichtung des Stellelements (13) mit der höheren Koerzitivfeldstärke nur durch alle drei Ströme (I_{A}, I_{B} und I_{C}) zusammen verstellt werden kann und die Magnetisierungsrichtung des Stellelements (12) mit der geringeren Koerzitivfeldstärke nur durch zwei (I_{A}, I_{B}) der drei Ströme verstellt werden kann, und
- die Einstellung der Logikeinrichtung (10) mit dem Operator-Steuersignal (SET) vor der Ausführung der Operatorfunktion F in zwei aufeinanderfolgenden Teilschritten erfolgt, wobei zunächst durch die gleichzeitige Bestromung mit allen drei Strömen (I_{A}, I_{B} und I_{C}) das Stellelement (13) mit der höheren Koerzitivfeldstärke und anschließend durch die gleichzeitige Bestromung mit zwei (I_{A}, I_{B}) der drei Ströme ausschließlich das Stellelement (12) mit der geringeren Koerzitivfeldstärke eingestellt wird.

2. Verfahren nach Anspruch 1, bei dem die Steuerstromsignale über Eingangsleitungen (14, 15, A, B, C) zur Eingabe der Eingangsgrößen (I_{A}, I_{B}) in die Logikeinrichtung (10) zugeführt werden.

3. Verfahren nach Anspruch 2, bei dem die Steuerstromsignale konstante Strombeträge aufweisen.

4. Verfahren nach einem der Ansprüche 1 order 2, dem die Steuerstromsignale getaktete Ströme umfassen.

5. Verfahren nach Anspruch 1, bei dem die Eingangsstromsignale und die Steuerstromsignale die gleichen Beträge aufweisen.

6. Verfahren zum Betrieb einer magnetischen Logikschaltung (30), die eine Vielzahl von Logikeinrichtungen (10) umfasst, mit denen gleichzeitig oder aufeinander folgend eine Vielzahl logischer Operationen gemäß einem Verfahren nach einem der vorhergehenden Ansprüche ausgeführt werden.

7. Verfahren nach Anspruch 6, bei dem jede Logikeinrichtung (10) aufeinander folgend gleiche oder verschiedene logische Operationen ausführt.

8. Logikeinrichtung (10) mit mindestens zwei Eingängen (14, 15) und mindestens einem Ausgang (16), verbunden mit einer Steuer-Schaltung (20), wobei die Logikeinrichtung (10) zur Ausführung mindestens einer logischen Operation vorgesehen ist, bei der aus Eingangsgrößen (I_{A}, I_{B}) mit einer Operatorfunktion F mindestens eine Ausgangsgröße O = F (I_{A}, I_{B}) gebildet wird, wobei die Steuerschaltung (20) zur Bereitstellung eines Operator-Steuersignals, das aus einer Gruppe von Steuerstromsignalen ausgewählt ist, unter deren Wirkung für verschiedene logische Funktionen charakteristische Startzustände der Logikeinrichtung (10) einstellbar sind, und zur Einstellung der Logikeinrichtung (10) auf einen dem Operator-Steuersignal entsprechenden Startzustand eingerichtet ist,
- die Logikeinrichtung (10) ein einziges magnetoresistives Element (11) mit zwei magnetischen Stellelementen (12, 13) mit verschiedenen Koerzitivfeldstärken umfasst, deren Eingänge (14, 15) die Eingänge der Logikeinrichtung (10) bilden und die mit den Eingangsgrößen (I_{A}, I_{B}) zur Ausführung der Operatorfunktion F beaufschlagbar sind,
- die Logikeinrichtung (10) eingerichtet ist, dass zur Ausführung der Operatorfunktion F die Eingänge (14, 15) der Stellelemente (12, 13) zur Eingabe der logischen Eingangsgrößen (I_{A}, I_{B}) mit Eingangsstromsignalen beaufschlagt werden, und
- die Steuerschaltung (20) eine Stromquelle (21) und eine Schalteinrichtung (22) aufweist, mit der das magnetoresistive Element (11) mit dem Operator-Steuersignal beaufschlagt werden kann,
**dadurch gekennzeichnet, dass**
- die Stromquelle (21) vorgesehen ist, das Operator-Steuersignal zu erzeugen, und die Stromquelle (21) über die Schalteinrichtung (22) mit den Eingängen (14, 15) der Stellelemente (12, 13) verbunden ist, und
- die Logikeinrichtung (10) mit dem Operator-Steuersignal auf einen nichtflüchtigen Startzustand einstellbar ist,
- an den zwei magnetischen Stellelemente mit den Steuerstromsignalen jeder von vier Startzuständen einstellbar ist, wobei mit den Steuerstromsignalen die Startzustände nichtflüchtig einstellbar sind, die jeweils für eine logische Funktion aus der Gruppe der logischen AND-, OR-, NAND- und NOR-Funktionen charakteristisch sind, und
- die Koerzitivfeldstärken der Stellelemente (12, 13) so abgestimmt sind und die Stromquelle (21) derart zur Bereitstellung von Strombeträgen der Steuerstromsignale eingerichtet ist, dass die Magnetisierungsrichtungen von beiden Stellelementen (12, 13) durch das Operator-Steuersignal verstellt werden können, um den Startzustand für die Ausführung der Operatorfunktion F zu bilden, wobei die Steuerschaltung (20) eingerichtet ist, die Steuerstromsignale aus drei Strömen (I_{A}, I_{B} und I_{C}) zu bilden und die Magnetisierungsrichtung des Stellelements (13) mit der höheren Koerzitivfeldstärke nur durch alle drei Ströme (I_{A}, I_{B} und I_{C}) zusammen verstellt werden kann und die Magnetisierungsrichtung des Stellelements (12) mit der geringeren Koerzitivfeldstärke nur durch zwei der drei Ströme (I_{A}, I_{B} und I_{C}) verstellt werden kann, und
- die Steuerschaltung (20) eingerichtet ist, die Logikeinrichtung (10) mit dem Operator-Steuersignal (SET) vor der Ausführung der Operatorfunktion F in zwei aufeinanderfolgenden Teilschritten einzustellen , wobei zunächst durch die gleichzeitige Bestromung mit allen drei Strömen (I_{A}, I_{B} und I_{C}) das Stellelement (13) mit der höheren Koerzitivfeldstärke und anschließend durch die gleichzeitige Bestromung mit zwei (I_{A}, I_{B}) der drei Ströme ausschließlich das Stellelement (12) mit der geringeren Koerzitivfeldstärke einstellbar ist.

9. Logikeinrichtung (10) nach Anspruch 8, bei der die Steuerschaltung (20) einen Operatorfunktions-Wähler (23) aufweist, mit dem das Operator-Steuersignal wählbar ist.

10. Logikschaltung (30), die eine Vielzahl von Logikeinrichtungen (10) nach einem der Ansprüche 8 oder 9 aufweist.

11. Logikschaltung nach Anspruch 10, bei der jede Logikeinrichtungen (10) mit einer separaten Steuerschaltung (20) verbunden ist.

12. Logikschaltung nach Anspruch 10, bei der die Logikeinrichtungen (10) gruppenweise oder sämtlich mit einer gemeinsamen Steuerschaltung (20) verbunden sind.

## Claims

1. A method for operating a magnetic logic device (10) in which at least one output variable O = F (I_{A}, I_{B}) is formed from input variables (I_{A}, I_{B}) by at least one logic operation with an operator function F of the magnetic logic device (10), wherein
- the logic device (10) is set with a certain operator control signal (SET) at a starting state for execution of the operator function F before the operation, whereby the operator control signal is selected from a group of control current signals, under the effect of which various starting states can be set in a controlled manner, each of these states being characteristic of a different logic function,
- the magnetic logic device (10) comprises one single magneto-resistive element (11) with two magnetic setting elements (12, 13), which have different coercitive field strengths,
- for executing the operator function F, input current signals are applied to inputs (14, 15) of the setting elements (12, 13) for inputting the logic input variables (I_{A}, I_{B}), and
- the magnetic logic device (10) is connected with a current source (21) and a switching device (22),
**characterized in that**
- the operator control signal is generated with the current source (21) and applied to the inputs (14, 15) of the setting elements (12, 13) using the switching device (22), and
- the logic device (10) is set with the operator control signal SET to a non-volatile logic state as starting state, wherein
- each of four starting states can be set at the two magnetic setting elements using the control current signals, wherein starting states can be set with the control current signals in a non-volatile manner, each of these states being characteristic of a logic function from the group of logic AND-, OR-, NAND- and NOR-functions,
- the coercitive field strengths of the setting elements (12, 13) and the current values of the control current signals are adjusted such that the magnetization directions of both setting elements (12, 13) can be set with the operator control signal in order to provide the starting state for the execution of the operator function F, wherein the control current signals are formed from three currents (I_{A}, I_{B} and I_{C}) and the magnetization direction of the setting element (13) with the larger coercitive field strength can be set only commonly by all three currents (I_{A}, I_{B} and I_{C}) and the magnetization direction of the setting element (12) with the lower coercitive field strength can be set by only two (I_{A}, I_{B}) of the three currents, and
- the setting of the logic device (10) with the operator control signal (SET) is conducted with two subsequent partial steps before the execution of the operator function, wherein firstly the setting element (13) with the larger coercitive field strength is set by the simultaneous application of all three currents (I_{A}, I_{B} and I_{C}) and subsequently exclusively the setting element (12) with the lower coercitive field strength is set by simultaneous application of two (I_{A}, I_{B}) of the three currents.

2. The method according to Claim 1, wherein, for inputting the input variables (I_{A}, I_{B}), the control current signals are sent via input lines (14, 15, A, B, C) into the logic device (10).

3. The method according to Claim 2, wherein the control current signals have constant current values.

4. The method according to one of Claims 1 or 2, wherein the control current signals include switched-mode currents.

5. The method according to Claim 1, wherein the input current signals and the control current signals have the same values.

6. The method for operating a magnetic logic circuit (30), comprising a plurality of logic devices (10) with which a plurality of logic operations are executed either simultaneously or in succession according to a method as **characterized in** any one of the preceding claims.

7. The method according to Claim 6, wherein each logic device (10) executes the same or different logic operations in succession.

8. A logic device (10) with at least two inputs (14, 15) and at least one output (16), connected with a control circuit (20), wherein the logic device (10) is provided for executing at least one logic operation in which at least one output variable O = F (I_{A}, I_{B}) is formed from input variables (I_{A}, I_{B}) with an operator function F, wherein the control circuit (20) is adapted for providing an operator control signal, which is selected from a group of control current signals, under the effect of which starting states of the logic device (10) being characteristic for various logic functions can be set, and for setting the logic device (10) to a starting state corresponding to the operator control signal,
wherein
- the logic device (10) comprises one single magnetoresistive element (11) with two magnetic setting elements (12, 13) with different coercitive field strengths, the inputs (14, 15) of which forming the inputs of the logic device (10) and to which the input variables (I_{A}, I_{B}) for executing the operator function F can be applied,
- the logic device (10) is configured so that for executing the operator function F input current signals are applied to the inputs (14, 15) of the setting elements (12, 13) for inputting the logic input variables (I_{A}, I_{B}), and
- the control circuit (20) has a current source (21) and a switching device (22), which is adapted for applying the operator control signal to the magneto-resistive element (11),
**characterized in that**
- the current source (21) is provided for generating the operator control signal and the current source (21) is connected via the switching device (22) with the inputs (14, 15) of the setting elements (12, 13), and
- the logic device (10) can be set with the operator control signal to a non-volatile starting state,
- each of four starting states can be set at the two magnetic setting elements with the control current signals, wherein the starting states can be set with the current control signals in a non-volatile manner, each of the starting states being characteristic for a logic function from the group of the logic AND-, OR-, NAND- and NOR-functions, and
- the coercitive field strengths of the setting elements (12, 13) are adapted and the current source (21) is configured for providing current values of the control current signals such that the magnetisation directions of both setting elements (12, 13) can be set by the operator control signal in order to form the starting state for the execution of the operator function F, wherein the control circuit (20) is configured to form the control current signals from three currents (I_{A}, I_{B} and I_{C}) and the magnetisation direction of the setting element (13) with the larger coercitive field strength can be set only commonly by all three currents (I_{A}, I_{B} and I_{C}) and the magnetization direction of the setting element (12) with the lower coercitive field strength can be set with only two of three currents (I_{A}, I_{B} and I_{C}), and
- the control circuit (20) is configured to set the logic device (10) with the operator control signal (SET) before the execution of the operator function F into subsequent partial steps, wherein firstly the setting element (13) with the larger coercitive field strength can be set by simultaneous application of all three currents (I_{A}, I_{B} and I_{C}) and subsequently exclusively the setting element (12) with the lower coercitive field strength can be set by the simultaneous application of two (I_{A}, I_{B}) of the three currents.

9. The logic device (10) according to Claim 8, wherein the control circuit (20) has an operator function selector (23) with which the operator control signal is selectable.

10. A logic circuit (30) having a plurality of logic devices (10) according to one of the Claims 8 or 9.

11. The logic circuit according to Claim 10, wherein each logic device (10) is connected to a separate control circuit (20).

12. The logic circuit according to Claim 10, wherein the logic devices (10) in groups or collectively are connected to a common control circuit (20).

## Revendications

1. Procédé pour la mise en service d'un dispositif logique magnétique (10), où au moins une grandeur de sortie O = F (I_{A}, I_{B}) est formée par au moins une opération logique à partir de grandeurs d'entrée (I_{A}, I_{B}) avec une fonction d'opérateur F du dispositif logique magnétique (10), où,
- préalablement à l'opération, le dispositif logique (10) est, au moyen d'un signal de commande d'opérateur (SET) défini, réglé sur un état de démarrage pour l'exécution de la fonction d'opérateur F, le signal de commande d'opérateur étant sélectionné dans un groupe de signaux de commande sous l'action desquels différents états de démarrage caractéristiques pour différentes fonctions logiques sont réglables de manière ciblée,
- le dispositif logique magnétique (10) comprend un seul élément magnéto-résistif (11) avec deux éléments de réglage magnétiques (12, 13) présentant des intensités de champ coercitif différentes,
- pour l'exécution de la fonction d'opérateur F, des signaux de courant d'entrée sont appliqués sur des entrées (14, 15) des éléments de réglage (12, 13) pour la saisie des grandeurs d'entrée logiques (I_{A}, I_{B}),
et
- le dispositif logique magnétique (10) est relié à une source de courant (21) et à un dispositif de commutation (22), **caractérisé**
- **en ce que** le signal de commande d'opérateur est généré par la source de courant (21) et est appliqué par le dispositif de commutation (22) sur les entrées (14, 15) des éléments de réglage (12, 13), et
- **en ce que** le dispositif logique (10) est réglé par le signal de commande d'opérateur (SET) sur un état logique non volatil en tant qu'état de démarrage,
- chaque état parmi quatre états de démarrage étant réglable par les signaux de courant de commande sur les deux éléments de réglage magnétiques, lesdits états de démarrage étant réglables de manière non volatile par les signaux de courant de commande chacun caractéristiques d'une fonction logique dans le groupe des fonctions AND, OR, NAND et NOR,
- **en ce que** les intensités de champ coercitif des éléments de réglage (12, 13) et les valeurs de courant des signaux de courant de commande sont réglées de manière à pouvoir régler les directions de magnétisation des deux éléments de réglage (12, 13) par le signal de commande d'opérateur, pour former l'état de démarrage pour l'exécution de la fonction d'opérateur F, les signaux de courant de commande étant formés à partir de trois courants (I_{A}, I_{B} et I_{C}) et la direction de magnétisation de l'élément de réglage (13) avec l'intensité de champ coercitif supérieure ne pouvant être réglée que par les trois courants (I_{A}, I_{B} et I_{C}) ensemble, et la direction de magnétisation de l'élément de réglage (12) avec l'intensité de champ coercitif inférieure ne pouvant être réglée que par deux (I_{A}, I_{B}) des trois courants, et
- **en ce que** le réglage du dispositif logique (10) avec le signal de commande d'opérateur (SET) préalablement à l'exécution de la fonction d'opérateur F est effectué en deux étapes partielles consécutives, l'élément de réglage (13) avec l'intensité de champ coercitif supérieure étant réglé dans un premier temps par application simultanée des trois courants (I_{A}, I_{B} et I_{C}), puis seul l'élément de réglage (12) d'intensité de champ coercitif inférieure par application simultanée de deux (I_{A}, I_{B}) des trois courants.

2. Procédé selon la revendication 1, où les signaux de courant de commande sont acheminés vers le dispositif logique (10) par des conduites d'entrée (14, 15, A, B, C) pour la saisie des grandeurs d'entrée (I_{A}, I_{B}).

3. Procédé selon la revendication 2, où les signaux de courant de commande présentent des valeurs de courant constantes.

4. Procédé selon l'une des revendications 1 ou 2, où les signaux de courant de commande comprennent des courants cadencés.

5. Procédé selon la revendication 1, où les signaux de courant d'entrée et les signaux de courant de commande sont de valeur identique.

6. Procédé pour la mise en service d'un circuit logique magnétique (30) comprenant une pluralité de dispositifs logiques (10), au moyen desquels plusieurs opérations logiques sont exécutées simultanément ou successivement conformément à un procédé selon l'une des revendications précédentes.

7. Procédé selon la revendication 6, où chaque dispositif logique (10) exécute successivement des opérations logiques identiques ou différentes.

8. Dispositif logique (10) avec au moins deux entrées (14, 15) et au moins une sortie (16) reliée à un circuit de commande (20), ledit dispositif logique (10) étant prévu pour l'exécution d'au moins une opération logique, où au moins une grandeur de sortie O = F (I_{A}, I_{B}) est formée avec une fonction d'opérateur F à partir de grandeurs d'entrée (I_{A}, I_{B}), où le circuit de commande (20) est prévu pour la préparation d'un signal de commande d'opérateur sélectionné dans un groupe de signaux de commande, sous l'action desquels différents états de démarrage du dispositif logique (10) caractéristiques pour différentes fonctions logiques sont réglables, et pour le réglage du dispositif logique (10) sur un état de démarrage correspondant au signal de commande d'opérateur,
- le dispositif logique (10) comprend un seul élément magnéto-résistif (11) avec deux éléments de réglage magnétiques (12, 13) présentant des intensités de champ coercitif différentes, dont les entrées (14, 15) forment les entrées du dispositif logique (10) et sur lesquels les grandeurs d'entrée logiques (I_{A}, I_{B}) sont applicables pour l'exécution de la fonction d'opérateur F,
- le dispositif logique (10) est conçu de telle manière que, pour l'exécution de la fonction d'opérateur F, des signaux de courant d'entrée sont appliqués sur les entrées (14, 15) des éléments de réglage (12, 13) pour la saisie des grandeurs d'entrée logiques (I_{A}, I_{B}), et où
- le circuit de commande (20) comporte une source de courant (21) et un dispositif de commutation (22) permettant d'appliquer le signal de commande d'opérateur sur l'élément magnéto-résistif (11),
**caractérisé**
- **en ce que** la source de courant (21) est prévue pour générer le signal de commande d'opérateur, et la source de courant (21) est reliée aux entrées (14, 15) des éléments de réglage (12, 13) par l'intermédiaire du dispositif de commutation (22), et
- **en ce que** le dispositif logique (10) est réglable par le signal de commande d'opérateur sur un état de démarrage non volatil
- chaque état parmi quatre états de démarrage est réglable par les signaux de courant de commande sur les deux éléments de réglage magnétiques, lesdits états de démarrage étant réglables de manière non volatile par les signaux de courant de commande caractéristiques chacun d'une fonction logique dans le groupe des fonctions AND, OR, NAND et NOR, et
- **en ce que** les intensités de champ coercitif des éléments de réglage (12, 13) sont réglées et la source de courant (21) prévue pour la préparation de valeurs de courant des signaux de courant de commande, de manière à permettre le réglage des directions de magnétisation des deux éléments de réglage (12, 13) par le signal de commande d'opérateur, pour former l'état de démarrage pour l'exécution de la fonction d'opérateur F, le circuit de commande (20) étant prévu pour former les signaux de courant de commande à partir de trois courants (I_{A}, I_{B} et I_{C}) et la direction de magnétisation de l'élément de réglage (13) avec l'intensité de champ coercitif supérieure ne pouvant être réglée que par les trois courants (I_{A}, I_{B} et I_{C}) ensemble, et la direction de magnétisation de l'élément de réglage (12) avec l'intensité de champ coercitif inférieure ne pouvant être réglée que par deux des trois courants (I_{A}, I_{B} et I_{C}), et
- **en ce que** le circuit de commande (20) est prévu pour régler le dispositif logique (10) avec le signal de commande d'opérateur (SET) préalablement à l'exécution de la fonction d'opérateur F en deux étapes partielles consécutives, l'élément de réglage (13) avec l'intensité de champ coercitif supérieure étant réglable dans un premier temps par application simultanée des trois courants (I_{A}, I_{B} et I_{C}), puis seul l'élément de réglage (12) d'intensité de champ coercitif inférieure par application simultanée de deux (I_{A}, I_{B}) des trois courants.

9. Dispositif logique (10) selon la revendication 8, où le circuit de commande (20) comporte un sélectionneur de fonction d'opérateur (23) permettant de sélectionner le signal de commande d'opérateur.

10. Circuit logique (30) comportant une pluralité de dispositifs logiques (10) selon l'une des revendications précédentes 8 ou 9.

11. Circuit logique selon la revendication 10, où chaque dispositif logique (10) est relié à un circuit de commande (20) séparé.

12. Circuit logique selon la revendication 10, où les dispositifs logiques (10) sont reliés par groupes ou ensemble à un circuit de commande (20) commun.
